# EUROPÄISCHE PATENTSCHRIFT

(11) **EP 0 472 086 B1**
(45) Veröffentlichungstag und Bekanntmachung des Hinweises auf die Patenterteilung: **11.01.1995**
(21) Anmeldenummer: 91113513.5
(22) Anmeldetag: 12.08.1991
(51) Int. Cl.: H05K 13/02, H05K 13/00

(54) **Verfahren und Vorrichtung zum Gurten von SMT-fähigen Halbleiterchips und damit bestückte SMD-Platine**
Method and apparatus for taping SMT-adapted semiconductor-chips and SMD-board equipped with these
Méthode et appareil pour enrubanner des puces électroniques semi-conductrices adaptées à la technologie de montage en surface et plaque aux composants montés en surface équipée de celles-ci

(30) Priorität: 23.08.1990 DE 4026665
(43) Veröffentlichungstag der Anmeldung: 26.02.1992
(73) Patentinhaber: SIEMENS AKTIENGESELLSCHAFT, 80333 München (DE)
(72) Erfinder: Scheuenpflug, Richard, W-8411 Kleinprüfeningen (DE)

(56) Entgegenhaltungen:
- EP-A- 0 276 539
- DE-A- 3 009 727
- DE-A- 3 630 317
- DE-A- 3 740 594
- DE-C- 1 039 444

## Beschreibung

Die Erfindung betrifft ein Verfahren nach dem Oberbegriff des Anspruchs 1 und eine Vorrichtung nach dem Oberbegriff des Anspruchs 6 zum Gurten von SMT-fähigen Halbleiterchips und eine damit bestückte SMD-Platine nach dem Oberbegriff des Anspruchs 8.

Das technische Problem besteht darin, einen geeignet ausgebildeten Halbleiterchip automatisierungsgerecht für die Weiterverarbeitung und Verbindung mit einer SMD(Surface Mounted Device)-Platine anzubieten. Zu diesem Zweck wird beispielsweise vorgeschlagen, bei Halbleiterchips, die im Scheibenverband auf einer Halbleitersubstratscheibe in einer gewünschten Schichtenfolge monolithisch erzeugt werden, deren von einer Isolierschicht umgebene Kontaktfenster mit Streifenkontakten zu versehen, wobei jeder Streifenkontakt vom jeweiligen Kontaktfenster auf der Isolierschicht bis zur Chipkante geführt ist. Derartige Halbleiterchips sind SMT(Surface Mount Technology)-fähig.

Der Erfindung liegt die Aufgabe zugrunde, ein Verfahren und eine Vorrichtung der eingangs genannten Art und eine damit bestückte SMD-Platine anzugeben, bei denen eine automatisierte Montage der Halbleiterchips ermöglicht wird.

Diese Aufgabe wird erfindungsgemäß durch ein Verfahren nach dem Anspruch 1, durch eine Vorrichtung nach dem Anspruch 6 und durch eine SMD-Platine nach dem Anspruch 8 gelöst.

Vorteilhafte Ausgestaltungen bzw. Weiterbildungen der Erfindung sind Gegenstand zusätzlicher Ansprüche.

Die SMT-fähigen Halbleiterchips können beim Gurten entweder mit ihrer Rückseite oder mit ihrer Vorderseite auf ein mit einer Klebeschicht versehenes Folienband aufgebracht werden. Das Folienband hat zum Transport eine entsprechende Perforation, oder es wird zur Versteifung mit einem entsprechenden Trägerband versehen, das dann die Transportperforation aufweist. Die Klebeschicht wird selektiv aufgebracht. Zum Schutz der Halbleiterchips wird zwischen das Folienband bzw. das versteifte Folienband eine Schutzfolie zwischengewickelt.

Die mit der Erfindung erzielten Vorteile bestehen insbesondere darin, daß folgendes erreicht wird:
- Extreme Packungsdichte.
- Elastische Verbindung zur Platine über den Leitkleber.
- Höchste Bestückungsleistung
- Problematischer Lötprozeß kann entfallen. (Dieser wird bei kleinerem Leadabstand immer kritischer).
- Gute Wärmeabführung aus dem Halbleiterkristall auf die Leiterbahn bzw. Platine, da kurze Wege von den Übergängen (Junctions).

Anhand von in den Figuren der Zeichnung rein schematisch dargestellten Ausführungsbeispielen wird die Erfindung im folgenden näher erläutert.
Es zeigen
FIG 1 eine perspektivische Ansicht einer Gurtverpackung,
FIG 2 eine Vorrichtung zum Gurten teilweise im Schnitt und
FIG 3 einen Ausschnitt einer SMD-Platine.

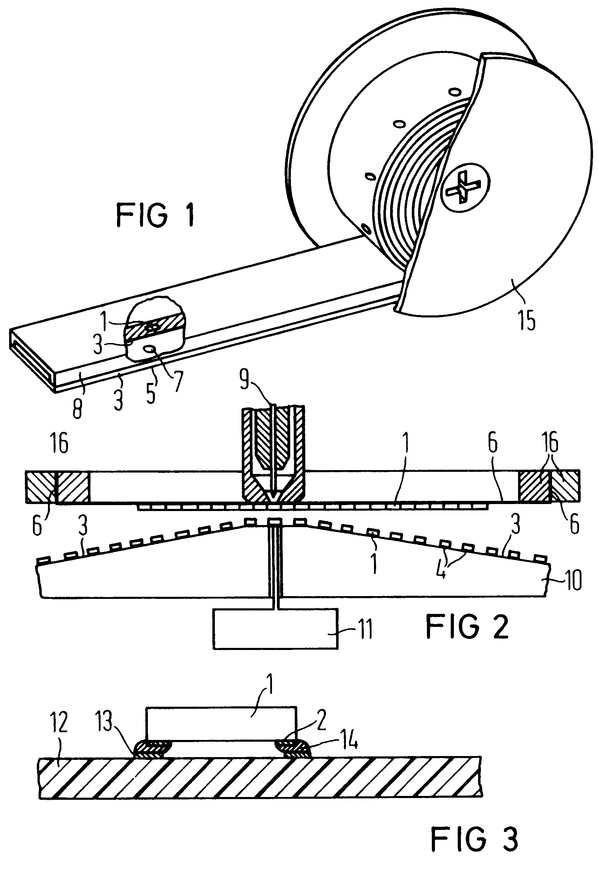

In FIG 1 ist eine Gurtverpackung zum Gurten der SMT-fähigen Halbleiterchips 1 dargestellt. Die Halbleiterchips 1, die auf ihrer Oberfläche bis zur Chipkante geführte Streifenkontakte 2 (FIG 3) aufweisen, sind bereits vereinzelt im Waferverband auf eine Selbstklebefolie 6 (FIG 2) aufgebracht. Auf das Folienband 3, das auf eine Spule 15 aufwickelbar ist, wird eine Klebeschicht 4 selektiv aufgebracht. Das Folienband 3 ist in diesem Beispiel auf ein mit einer Transportperforation 7 versehenes Trägerband 5 aufgebracht. Die auf dem Folienband 3 aufgebrachten Halbleiterchips 1 werden zweckmäßig noch mit einer Schutzfolie 8 abgedeckt, die in diesem Beispiel U-förmig ausgebildet ist. Die Halbleiterchips 1 werden nacheinander von der Selbstklebefolie 6 (FIG 2) gelöst und in definierten Abständen auf das Folienband 3 aufgebracht und mit diesem verklebt. Zum Aufkleben der Halbleiterchips 1 mit der Rückseite auf das Folienband 3 ist die in FIG 2 gezeigte Vorrichtung besonders geeignet.

Mit der in FIG 2 dargestellten Vorrichtung werden die SMT-fähigen Halbleiterchips 1, die bereits vereinzelt im Waferverband auf einer Selbstklebefolie 6 aufgebracht sind, die in zwei Spannringe 16 eingeklemmt ist, auf das Folienband 3 zum Gurten aufgebracht. Das Folienband 3 wird an vorgegebenen Stellen mit einer Klebeschicht 4 versehen, auf die die Halbleiterchips 1 aufgeklebt werden. Die vereinzelten, im Waferverband befindlichen Halbleiterchips 1 werden in einem geringen Abstand von ≦ 0,2mm über das auf einem X-Y-Kreuztisch 10 geführte Folienband gebracht. Der Waferverband wird mittels einer optoelektronischen Justiereinrichtung 11 zu dem auf dem X-Y-Kreuztisch 10 geführten Folienband 3 so ausgerichtet, daß die aufzubringende Fläche, d.h. in diesem Beispiel die Rückseite des Halbleiterchips 1 jeweils einer mit der Klebeschicht 4 versehenen Stelle des Folienbandes 3 gegenüberliegt. Zum Stoßen des Halbleiterchips 1 aus dem Waferverband auf die jeweilige mit der Klebeschicht 4 versehene Stelle des Folienbandes 3 ist eine Stoßvorrichtung 9 vorgesehen, die vorzugsweise als elektromechanisch betriebener Druckstift (push down pin) ausgebildet ist.

Diese Ausführung ist nun besonders geeignet, mit der beschriebenen Vorrichtung die SMT-fähigen Halbleiterchips 1 direkt auf eine SMD-Platine zu bringen. Eine solche SMD-Platine ist in FIG 3 dargestellt. Um die Halbleiterchips 1 auf die SMD-Platine 12 aufzubringen, dreht man die Spule 15 (FIG 1) um 180° und zieht das mit den Halbleiterchips 1 bestückte Folienband 3 so ab, daß die Halbleiterchips wieder mit der Aktivseite, d.h. mit der Vorderseite bzw. mit der die Streifenkontakte 2 aufweisenden Seite nach unten weisen. Die SMD-Platine 12 ist auf den Anschlußpads 13 beispielsweise durch ein Siebdruckverfahren mit Leitkleber 14 versehen. Die auf einem X-Y-Kreuztisch 10 (FIG 2) befindliche SMD-Platine 12 fährt nun in die sogenannte push down-Position, und der Halbleiterchip 1 wird mit seinen Streifenkontakten 2 auf die mit Leitkleber 14 versehenen Anschlußpads 13 gedrückt und durch Adhäsion übernommen. Die Klebeverbindung wird dann durch ein geeignetes Aushärteverfahren gefestigt.

Sofern die Halbleiterchips 1 mit der Vorderseite auf das Folienband 3 aufgebracht werden sollen, ist es notwendig, daß die im Scheibenverband vereinzelten Halbleiterchips 1 auf der Selbstklebefolie 6 (FIG 2) nochmals umgeklebt werden. Sodann können die Halbleiterchips mit dem beschriebenen Verfahren bzw. der Vorrichtung auf das Folienband 3 aufgebracht werden. Der Anwender kann bei dieser Ausführungsform des Gurtens nun die Halbleiterchips 1 mit der an sich bekannten sogenannten pick and place-Methode von dem Folienband 3 abnehmen.

## Patentansprüche

1. Verfahren zum Gurten von SMT-fähigen Halbleiterchips, die auf ihrer Oberfläche bis zur Chipkante geführte Streifenkontakte aufweisen und bereits vereinzelt im Waferverband auf einer Selbstklebefolie aufgebracht sind, **dadurch gekennzeichnet**, daß auf ein Folienband (3) selektiv eine Klebeschicht (4) aufgebracht wird, und daß die Halbleiterchips (1) nacheinander von der Selbstklebefolie (6) gelöst und in definierten Abständen auf das Folienband (3) aufgebracht und mit diesem verklebt werden.

2. Verfahren nach Anspruch 1, **dadurch gekennzeichnet**, daß das Folienband (3) mit einer Transportperforation (7) versehen wird.

3. Verfahren nach Anspruch 1, **dadurch gekennzeichnet**, daß das Folienband (3) auf ein mit einer Transportperforation (7) versehenes Trägerband (5) aufgebracht wird.

4. Verfahren nach einem der Ansprüche 1 bis 3, **dadurch gekennzeichnet**, daß die auf dem Folienband (3) aufgebrachten Halbleiterchips (1) mit einer Schutzfolie (8) abgedeckt werden.

5. Verfahren nach einem der Ansprüche 1 bis 4, **dadurch gekennzeichnet**, daß das Folienband (3) an vorgegebenen Stellen mit einer Klebeschicht (4) versehen wird, daß die vereinzelten, im Waferverband auf Selbstklebefolie (6) befindlichen Halbleiterchips (1) in einem geringen Abstand von ≦ 0,2mm über das Folienband (3) gebracht werden, daß der Waferverband so ausgerichtet wird, daß die zu verbindende Fläche jeweils eines Halbleiterchips (1) einer mit Kleber (4) versehenen Stelle des Folienbandes (3) gegenüberliegt, und daß der Halbleiterchip (1) mittels einer Stoßvorrichtung (9) aus dem Waferverband auf die mit Kleber (4) versehene Stelle des Folienbandes (3) gestoßen und mit diesem verklebt wird.

6. Vorrichtung zum Gurten von SMT-fähigen Halbleiterchips, die bereits vereinzelt im Waferverband auf einer Selbstklebefolie aufgebracht sind, **dadurch gekennzeichnet**, daß auf ein Folienband (3) an vorgegebenen Stellen eine Klebeschicht (4) aufgebracht ist, daß der vereinzelte, im Waferverband auf Selbstklebefolie (6) befindliche Halbleiterchip (1) in einem geringen Abstand von ≦ 0,2mm über das auf einem X-Y-Kreuztisch (10) geführte Folienband (3) gebracht ist, daß der Waferverband mittels einer optoelektronischen Justiereinrichtung (11) zu dem auf dem X-Y-Kreuztisch (10) geführten Folienband (3) so ausgerichtet ist, daß die aufzubringende Fläche eines Halbleiterchips (1) einer mit der Klebeschicht (4) versehenen Stelle gegenüberliegt, und daß zum Stoßen des Halbleiterchips (1) aus dem Waferverband auf die mit der Kleberschicht (4) versehene Stelle des Folienbandes (3) eine Stoßvorrichtung (9) vorgesehen ist.

7. Vorrichtung nach Anspruch 6, **dadurch gekennzeichnet**, daß die Stoßvorrichtung (9) ein elektromechanisch betriebener Druckstift ist.

8. Verfahren zum Bestücken einer SMD-Platine mit SMT-fähigen Halbleiterchips, die in definierten Abständen auf ein Folienband aufgebracht und mit diesem verklebt sind, **dadurch gekennzeichnet**, daß die mit Anschlußpads (13) versehene und auf einem X-Y-Kreuztisch (9) befindliche Platine (12) an vorgegebenen Stellen auf den Anschlußpads (13) mit einem Leitkleber (14) versehen wird, und daß die Halbleiterchips (1) aus dem Folienband (3) heraus auf die mit Leitkleber (14) versehenen Anschlußpads (13) gedrückt und auf diesen befestigt werden.

## Claims

1. Process for the strip mounting of SMT-capable semiconductor chips, which have ribbon contacts led on their surface up to the chip edge and are applied already separated in the wafer matrix to a self-adhesive foil, characterised in that an adhesive layer (4) is applied selectively to a foil tape (3), and in that the semiconductor chips (1) are detached sequentially from the self-adhesive foil (6) and applied at defined separations to the foil tape (3) and bonded thereto.

2. Process according to Claim 1, characterised in that the foil tape (3) is provided with a transport perforation (7).

3. Process according to Claim 1, characterised in that the foil tape (3) is applied to a carrier tape (5) provided with a transport perforation (7).

4. Process according to one of Claims 1 to 3, characterised in that the semiconductor chips (1) applied to the foil tape (3) are covered with a protective foil (8).

5. Process according to one of Claims 1 to 4, characterised in that the foil tape (3) is provided at prescribed locations with an adhesive layer (4), in that the separated semiconductor chips (1) located in the wafer matrix on self-adhesive foil (6) are brought at a slight separation of ≦ 0.2 mm over the foil tape (3), in that the wafer matrix is aligned in such a way that in each case the surface of a semiconductor chip (1) to be connected is opposite a location of the foil tape (3) that is provided with the adhesive (4), and in that the semiconductor chip (1) is pushed by means of a pusher (9) from the wafer matrix onto the location of the foil tape (3) that is provided with the adhesive (4), and bonded to said tape.

6. Device for the strip mounting of SMT-capable semiconductor chips that have already been applied separately in the wafer matrix to a self-adhesive foil, characterised in that an adhesive layer (4) is applied at prescribed locations to a foil tape (3), in that the separated semiconductor chip (1) located in the wafer matrix on self-adhesive foil (6) is brought at a slight separation of ≦ 0.2 mm over the foil tape (3) guided on an X-Y cross table (10), in that the wafer matrix is aligned by means of an optoelectronic alignment device (11) with respect to the foil tape (3) guided on the X-Y cross table (10) in such a way that the surface of a semiconductor chip (1) to be applied is opposite a location provided with the adhesive layer (4) and in that a pusher (9) is provided for the purpose of pushing the semiconductor chip (1) from the wafer matrix onto the location of the foil tape (3) that is provided with the adhesive layer (4).

7. Device according to Claim 6, characterised in that the pusher (9) is an electromechanically operated push down pin.

8. Process for mounting an SMD board with SMT-capable semiconductor chips, which are applied at defined separations to a foil tape and bonded thereto, characterised in that the board (12), which is provided with connection pads (13) and located on an X-Y cross table (9), is provided at prescribed locations on the connection pads (13) with a conductive adhesive (14), and in that the semiconductor chips (1) are pressed out of the foil tape (3) onto the connection pads (13) provided with conductive adhesive (14), and mounted on said connection pads.

## Revendications

1. Procédé pour mettre dans une bande des microcomposants semiconducteurs adaptés à la technique de montage en surface TMS, qui possèdent, sur leur surface, des contacts en forme de bandes qui s'étendent jusqu'au bord du microcomposant et qui sont déposés déjà en étant séparés les uns des autres en une tranche semiconductrice sur une feuille autoadhésive, caractérisé par le fait qu'on dépose de façon sélective une couche de colle (4) sur une feuille (3) en forme de bande et qu'on détache successivement les microcomposants semiconducteurs (1) de la feuille autoadhésive (6) et qu'on les dépose à des distances définies sur la feuille en forme de bande (3) et qu'on les colle à cette dernière.

2. Procédé suivant la revendication 1, caractérisé par le fait qu'on munit la feuille en forme de bande (3) de perforations de transport (7).

3. Procédé suivant la revendication 1, caractérisé par le fait qu'on dépose la feuille en forme de bande (3) sur une bande de support (5) comportant des perforations de transport (7).

4. Procédé suivant l'une des revendications 1 à 3, caractérisé par le fait qu'on recouvre les microcomposants semiconducteurs (1) déposés sur la feuille en forme de bande (3), d'une feuille de protection (8).

5. Procédé suivant l'une des revendications 1 à 4, caractérisé par le fait qu'on applique une couche de colle (4) en des emplacements prédéterminés sur la feuille en forme de bande (3), on amène les microcomposants semiconducteurs (1) séparés les uns des autres et étant en tranche semiconductrice sur la feuille autoadhésive (6), à une distance petite ≦0,2 mm au-dessus de la feuille en forme de bande (3), on aligne la tranche semiconductrice de manière que la surface à relier respectivement d'un microcomposant semiconducteur (1) se situe en vis-à-vis d'un emplacement, pourvu de la colle (4), de la feuille en forme de bande (3), et on repousse le microcomposant semiconducteur (1) au moyen d'un dispositif de poussée (9), hors de la tranche semi-conductrice, sur l'emplacement, pourvu de la colle (4), de la feuille en forme de bande (3), et on colle le microcomposant sur cette bande.

6. Dispositif pour mettre sur une bande des microcomposants à semiconducteurs adaptés à la technique de montage en surface TMS, qui sont déjà déposés d'une manière séparée les uns des autres, en une tranche semiconductrice sur une feuille autoadhésive, caractérisé par le fait qu'une couche de colle (4) est déposé en des emplacements prédéterminés sur une feuille en forme de bande (3), le microcomposant semiconducteur séparé (1) étant en tranche semiconductrice sur la feuille autoadhésive (6), est amené à une distance petite ≦0,2 mm au-dessus de la feuille en forme de bande (3) amenée sur une table à mouvements croisés X-Y (10), la tranche semiconductrice est alignée au moyen d'un dispositif d'ajustement optoélectronique (11) sur la feuille en forme de bande (3) amenée sur la table à mouvements croisés X-Y (10) de manière que la surface devant être appliquée d'un microcomposant semiconducteur (1) soit située en vis-à-vis d'un emplacement garni de la couche de colle (4), et que pour repousser le microcomposant semiconducteur (1) hors de la tranche semiconductrice sur l'emplacement, pourvu de la couche de colle (4), de la feuille en forme de bande (3), il est prévu un dispositif de poussée (9).

7. Dispositif suivant la revendication 6, caractérisé par le fait que le dispositif de poussée (9) est une tige d'éjection actionnée d'une manière électromécanique.

8. Procédé pour équiper une carte adaptée à la technologie de montage en surface TMS avec des microcomposants semiconducteurs TMS aptes à être montés en surface, qui sont déposés à des distances définies sur une feuille en forme de bande et sont collés à cette dernière, caractérisé par le fait qu'on applique une colle conductrice (14) en des emplacements prédéterminés de la carte (12), qui est pourvue de plots de raccordement (13) et qui se trouve sur une table à mouvements croisés X-Y (9), sur les plots de connexion (13), et on applique les microcomposants semiconducteurs (1) sur les plots de connexion (13) pourvus de la colle conductrice (14) en les retirant de la feuille en forme de bande (3) et on les fixe sur ces plots.
